# FASCICULE DE BREVET EUROPEEN

(11) **EP 0 643 492 B1**
(45) Date de publication et mention de la délivrance du brevet: **28.04.1999**
(21) Numéro de dépôt: 94202561.0
(22) Date de dépôt: 07.09.1994
(51) Int. Cl.: H03M 13/00

(54) **Système de transmission et modem utilisant des modulations codées**
Übertragungssystem und Modem mit kodierter Modulation
Transmission system and modem using coded modulations

(30) Priorité: 13.09.1993 FR 9310865
(43) Date de publication de la demande: 15.03.1995
(73) Titulaire: Koninklijke Philips Electronics N.V., 5621 BA Eindhoven (NL)
(72) Inventeur: Botto, Jean-Luc, F-75008 Paris (FR); Lepitre, Didier, F-75008 Paris (FR)
(74) Mandataire: Chaffraix, Jean

(56) Documents cités:
- EP-A- 0 455 089
- WO-A-93/06550
- US-A- 4 247 944
- US-A- 4 646 325
- US-A- 4 709 377
- PATENT ABSTRACTS OF JAPAN vol. 9, no. 4 (E-288) (1727) 10 Janvier 1985 & JP-A-59 153 350 (NIPPON DENSHIN DENWA KOSHA KK) 1 Septembre 1984
- MICROPROCESSORS AND MICROSYSTEMS, vol.15, no.1, Janvier 1991, LONDON GB pages 54 - 62 MESSER 'Convolutional encoding and Viterbi decoding using the DSP 56001'
- JOURNAL OF THE INSTITUTION OF ELECTRONIC AND RADIO ENGINEERS, vol.56, no.5, Mai 1986, LONDON GB pages 197 - 206 AFTELAK & CLARK 'Adaptive reduced-state Viterbi algorithm detector'

## Description

La présente invention concerne un système de transmission utilisant des modulations codées en treillis basées sur une constellation décomposée en N sous-ensembles, et comportant une source de données et un récepteur de données qui comporte lui-même un dispositif de décision permettant de déterminer le point le plus proche d'un symbole reçu dans chaque sous-ensemble de la constellation, lui associant ainsi une combinaison de N points.

L'invention concerne également un modem comportant un tel dispositif de décision.

Le codage en treillis trouve actuellement d'importantes applications dans le domaine des modulations numériques. Il consiste à décomposer la constellation en sous-ensembles qui sont choisis de telle sorte que la distance euclidienne carrée minimum séparant deux points d'un même sous-ensemble soit maximale. Il est donc possible de diviser plusieurs fois la constellation jusqu'à obtenir la distance souhaitée.

Ainsi, pour transmettre Q éléments binaires d'information, on ajoute P éléments binaires de redondance utilisant donc une constellation de 2^{Q+P} points (dans la pratique P est en général fixé égal à 1) : M des Q éléments binaires d'information sont alors utilisés par un codeur convolutif de taux M/M+P(ce qui correspond à l'ajout de P éléments binaires de redondance) pour désigner l'un des 2^{M+P} sous-ensembles de la constellation; et les Q-M éléments binaires restant servent à déterminer, à l'intérieur d'un sous-ensemble désigné, l'un des 2^{Q-M} points.

Le comportement d'un codeur convolutif est décrit par un treillis dont chaque branche représente la transition d'un état à un autre du codeur convolutif par transmission d'un point d'un sous-ensemble donné de la constellation.

L'algorithme de Viterbi est connu pour être une méthode optimale de décodage de ces codes convolutifs. Son principe est décrit dans l'article "The Viterbi Algorithm" de G. David Forney paru le 3 mars 1973 dans la revue "Proceedings of the IEEE". Rappelons simplement que la première étape de cet algorithme consiste, pour chaque symbole reçu, à déterminer le symbole qui en est le plus proche, au sens de la distance euclidienne, dans chaque sous-ensemble de la constellation.

Pour cela, il est connu de calculer, pour chacun des sous-ensembles de la constellation, les distances séparant le symbole reçu de chacun des points du sous-ensemble considéré, puis de choisir le symbole de ce sous-ensemble qui correspond à la distance minimale.

Cette méthode nécessite donc d'effectuer un nombre important de calculs, directement proportionnel à la taille de la constellation utilisée. Par exemple, lorsqu'on passe d'une vitesse de transmission de 12000 eb/s (ce qui correspond à une constellation de 8 sous-ensembles de 8 points) à une vitesse de 14400 eb/s (ce qui correspond à une constellation de 8 sous-ensembles de 16 points), le nombre de calcul double. Ainsi, pour des vitesses de transmission élevées, le nombre de calculs à effectuer augmente de façon considérable. De plus, la recherche du symbole correspondant à la distance minimale doit être effectuée autant de fois qu'il y a de sous-ensembles.

L'invention a pour but de proposer un système de transmission pour modulations codées comportant un récepteur dont le dispositif de décision ne présente pas ces inconvénients.

Pour cela, un système de transmission selon l'invention et tel que décrit dans le paragraphe introductif est caractérisé en ce que la constellation étant découpée en zones correspondant chacune à une combinaison donnée de N points, ledit dispositif de décision comporte un module de recherche de la zone dans laquelle se situe le symbole reçu, et une table dont la lecture fournit la combinaison correspondant à cette zone.

Ainsi, le dispositif de décision d'un récepteur d'un système de transmission selon l'invention ne met en oeuvre aucun calcul de distance. Seules une recherche de la zone du plan complexe qui contient le symbole reçu, et une unique lecture de table sont nécessaires pour déterminer la combinaison de N points associée au symbole reçu.

Dans un mode de réalisation préférentiel, le module de recherche de zone détermine la zone recherchée par dichotomie relativement aux frontières des différentes zones. Et de façon avantageuse, les frontières utilisées sont des droites.

Seuls quelques tests sont donc nécessaires pour déterminer la zone recherchée.

Dans un autre mode de réalisation avantageux, de façon à en simplifier la mise en oeuvre, un dispositif de décision d'un récepteur d'un système de transmission selon l'invention comporte un module de pré-traitement qui permet de ramener par symétrie tout point reçu dans un des quatre quadrants du plan, choisi comme référence pour y effectuer la recherche, et dit quadrant de référence, et en ce que les numéros de zone dans chacun des quadrants sont choisis de telle sorte qu'une opération mathématique "addition d'une constante" permette de passer du numéro de zone obtenu dans le quadrant de référence aux numéros des zones qui lui sont symétriques par rapport aux axes du plan de la constellation dans les autres quadrants.

L'invention a également pour but de proposer un modem utilisant les dites modulations, qui comprend un dispositif de décision comportant lui-même un module de recherche de la zone dans laquelle se situe le symbole reçu, et une table dont la lecture fournit la combinaison correspondant à cette zone.

D'autres particularités, détails et avantages de l'invention seront mis en évidence par la description qui va suivre en regard des dessins annexés qui sont donnés à titre d'exemples non limitatifs et dans lesquels :
- la figure 1 représente schématiquement un système de transmission selon l'invention,
- la figure 2 représente la constellation utilisée dans la recommandation V32/V32bis pour des modulations codées en treillis à 9600eb/s,
- la figure 3 représente un exemple de découpage en zones d'un quadrant du plan pour cette même constellation,
- la figure 4 est un schéma d'un exemple de dispositif de décision d'un récepteur d'un système de transmission selon l'invention,
- la figure 5 représente l'organigramme d'un exemple d'algorithme de recherche de zones,
- la figure 6 représente un modem selon l'invention.

Dans la suite de la description, on a choisi de considérer un débit binaire de 9600eb/s pour la simplicité de l'exposé. Toutefois, il ne faut pas perdre de vue que ledit dispositif de décision est d'autant plus avantageux que le nombre de points de la constellation est élevé, c'est-à-dire que le débit binaire est important.

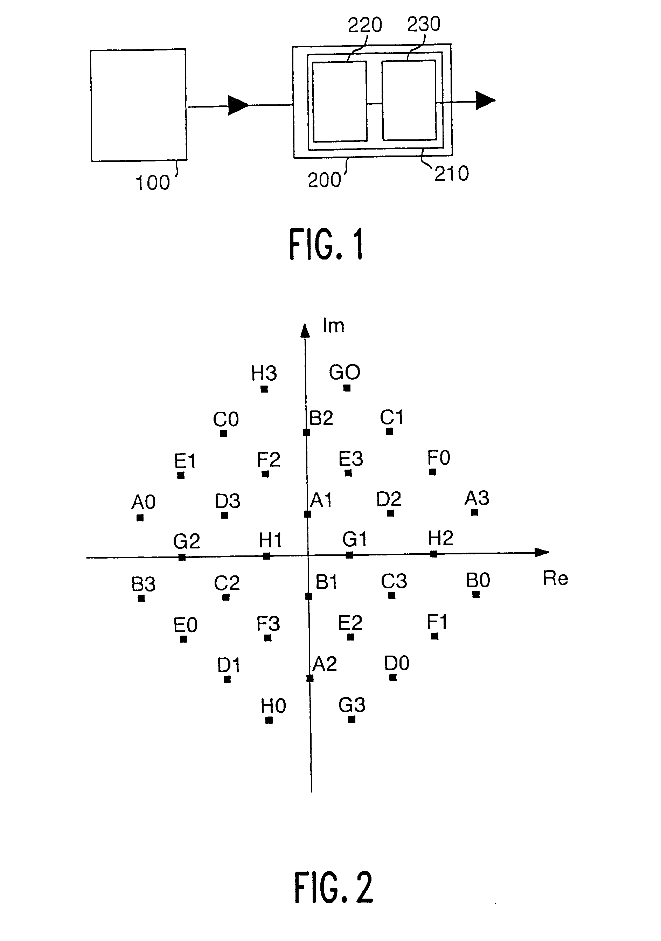

La figure 1 représente de façon schématique un système de transmission selon l'invention, utilisant des modulations codées en treillis basées sur une constellation décomposée en N sous-ensembles. Un tel système comporte une source de données 100 et un récepteur de données 200. Ce récepteur de données comporte notamment un décodeur 210 destiné à décoder les dites modulations, ce décodeur comportant lui-même un dispositif de décision 220. Les données issues du dispositif de décision 220 sont fournies à un module de traitement 230 qui réalise le traitement classique d'un décodeur de Viterbi et n'a donc pas à être décrit ici. Les données de sortie du décodeur 210 sont délivrées à un utilisateur.

La figure 2 représente la constellation utilisée par la recommandation V32/V32bis pour les modulations codées en treillis à 9600eb/s.

Cette constellation comporte 32 points répartis en huit sous-ensembles de quatre points chacun. Ces sous-ensembles sont référencés par les lettres A à H, et à l'intérieur de chacun d'eux les points sont numérotés de 0 à 3. A chaque point de la constellation est associé un mot binaire Y0 Y1 Y2 Q3 Q4, les éléments binaires Y0, Y1 et Y2 d'une part et Q3 et Q4 d'autre part étant respectivement utilisés pour coder le sous-ensemble et le point à l'intérieur de ce sous-ensemble. Les tableaux 1 et 2 donnés ci-dessous indiquent la correspondance entre les références utilisées sur les figures (A0 à H3) et les mots binaires fixés par la recommandation V32bis.

**TABLEAU 1**

| sous-ensemble | Y₀ | Y₁ | Y₂ |
|---|---|---|---|
| A | 0 | 0 | 0 |
| B | 0 | 0 | 1 |
| C | 0 | 1 | 0 |
| D | 0 | 1 | 1 |
| E | 1 | 0 | 0 |
| F | 1 | 0 | 1 |
| G | 1 | 1 | 0 |
| H | 1 | 1 | 1 |

**TABLEAU 2**

| point | Q₃ | Q₄ |
|---|---|---|
| 0 | 0 | 0 |
| 1 | 1 | 0 |
| 2 | 0 | 1 |
| 3 | 1 | 1 |

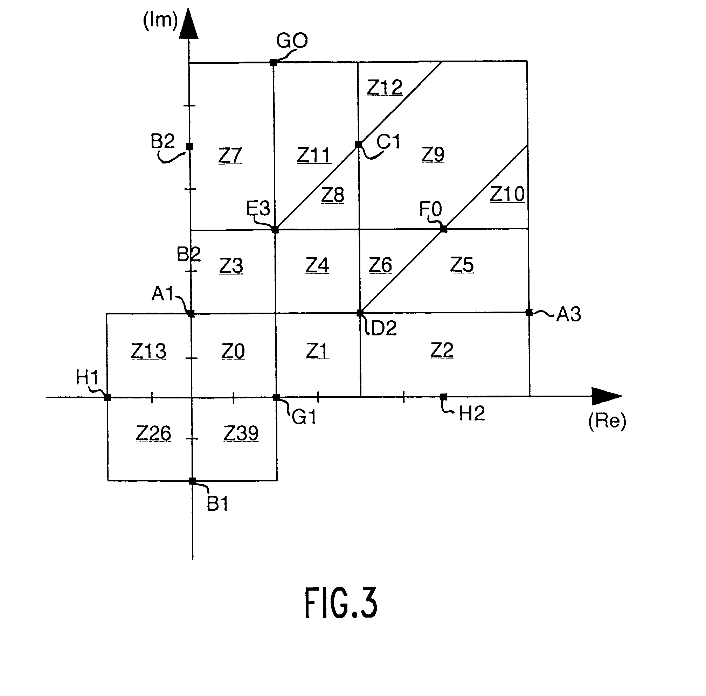

La figure 3 représente le découpage en treize zones du quadrant (X>0, Y>0) servant de référence pour les calculs de recherche de zone. Ces treize zones ont été délimitées en calculant pour un grand nombre de points reçus très proches les uns des autres, les distances euclidiennes qui les séparent de tous les points de la constellation de façon à déterminer la combinaison des huit points les plus proches associée à chacun d'eux. Chaque zone est ensuite formée par l'ensemble des points reçus pour lesquels une même combinaison a été déterminée. Ces zones sont numérotées Z0 à Z12.

Les numéros des zones des quadrants (X<0, Y>0), (X<0, Y<0) et (X>0, Y<0) sont obtenus en ajoutant respectivement +13, +26, et +39 aux numéros des zones du quadrant de référence dont elles sont le symétrique par rapport aux axes réel (Re) et imaginaire (Im) du plan complexe. Ainsi, la zone du quadrant (X<0, Y>0) symétrique de la zone Z0 par rapport à l'axe imaginaire est numérotée Z13, la zone du quadrant (X<0, Y<0) symétrique de la zone Z0 par rapport à l'origine est numérotée Z26, et enfin la zone du quadrant (X>0, Y<0) symétrique de la zone Z0 par rapport à l'axe réel est numérotée Z39. Cette numérotation permet, à partir du numéro d'une zone calculé dans le quadrant de référence, d'obtenir facilement le numéro d'une autre zone qui lui est symétrique dans un autre quadrant.

Le tableau 3 indique les combinaisons de huit points obtenues pour chaque zone de chaque quadrant.

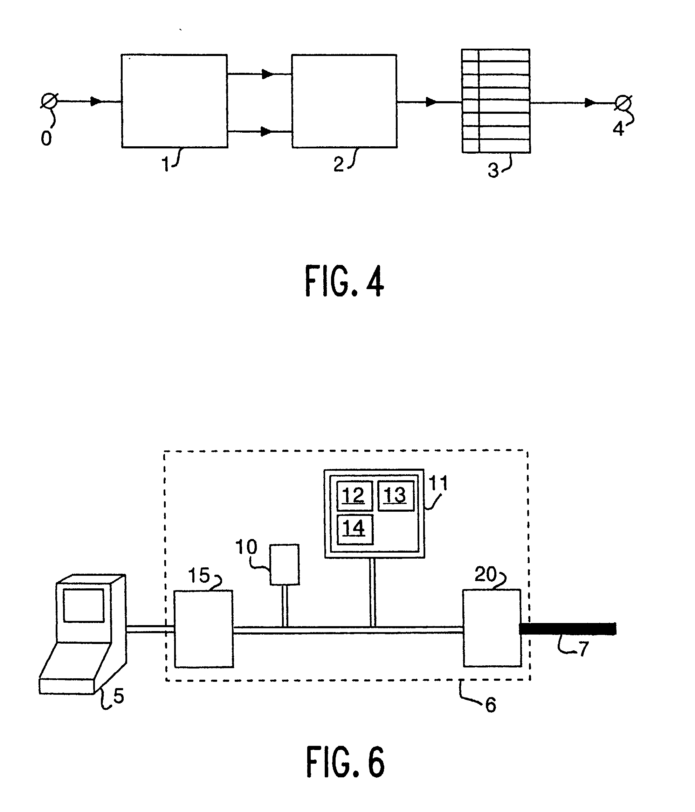

D'après la figure 4, un dispositif de décision d'un récepteur d'un système de transmission selon l'invention comporte un module 1 de pré-traitement relié à une entrée 0 délivrant les coordonnées d'un point reçu, et un module 2 de recherche de zone qui commande la lecture d'une table 3 contenant les combinaisons de huit points associées à chaque zone de la constellation. Les seize éléments binaires résultant d'une telle lecture sont délivrés sur une sortie 4.

Le module 1 de pré-traitement dispose en entrée des coordonnées Xr et Yr du point reçu R. Il localise ce point reçu R dans l'un des quatre quadrants du plan complexe en testant ces coordonnées Xr et Yr par rapport à l'origine (0, 0). Dans le cas où le quadrant obtenu est autre que le quadrant de référence (X>0, Y>0), le point reçu R est y ramené par symétrie par rapport aux axes imaginaire et/ou réel du plan complexe (Xr devient -Xr et/ou Yr devient -Yr). Un nouveau point R' de coordonnées Xr' et Yr' est ainsi obtenu.

Le quadrant initial du point reçu R est ensuite mémorisé par l'intermédiaire d'une variable index de la façon suivante :
- si R est dans le premier quadrant (Xr>0, Yr>0) : index = 0,
- si R est dans le second quadrant (Xr<0, Yr>0) : index = 13,
- si R est dans le troisième quadrant (Xr<0, Yr<0) : index = 26,
- si R est dans le quatrième quadrant (Xr>0, Yr<0) : index = 39.
Les coordonnées Xr' et Yr' du point R' et la variable index sont transmises au module 2 de recherche de zone.

**TABLEAU 3**

| 1er quadrant | | | | | | | | |
|---|---|---|---|---|---|---|---|---|
| zone 0 | A1 | B1 | C3 | D2 | E3 | F2 | G1 | H1 |
| 1 | A1 | B1 | C3 | D2 | E3 | F0 | G1 | H2 |
| 2 | A3 | B0 | C3 | D2 | E3 | F0 | G1 | H2 |
| 3 | A1 | B2 | C1 | D2 | E3 | F2 | G1 | H1 |
| 4 | A1 | B2 | C1 | D2 | E3 | F0 | G1 | H2 |
| 5 | A3 | B0 | C1 | D2 | E3 | F0 | G1 | H2 |
| 6 | A3 | B2 | C1 | D2 | E3 | F0 | G1 | H2 |
| 7 | A1 | B2 | C1 | D2 | E3 | F2 | G0 | H3 |
| 8 | A1 | B2 | C1 | D2 | E3 | F0 | G0 | H2 |
| 9 | A3 | B2 | C1 | D2 | E3 | F0 | G0 | H2 |
| 10 | A3 | B0 | C1 | D2 | E3 | F0 | G0 | H2 |
| 11 | A1 | B2 | C1 | D2 | E3 | F0 | G0 | H3 |
| 12 | A3 | B2 | C1 | D2 | E3 | F0 | G0 | H3 |

| 2ème quadrant | | | | | | | | |
|---|---|---|---|---|---|---|---|---|
| zone 13 | A1 | B1 | C2 | D3 | E3 | F2 | G1 | H1 |
| 14 | A1 | B1 | C2 | D3 | E1 | F2 | G2 | H1 |
| 15 | A0 | B3 | C2 | D3 | E1 | F2 | G2 | H1 |
| 16 | A1 | B2 | C0 | D3 | E3 | F2 | G1 | H1 |
| 17 | A1 | B2 | C0 | D3 | E1 | F2 | G2 | H1 |
| 18 | A0 | B3 | C0 | D3 | E1 | F2 | G2 | H1 |
| 19 | A0 | B2 | C0 | D3 | E1 | F2 | G2 | H1 |
| 20 | A1 | B2 | C0 | D3 | E3 | F2 | G0 | H3 |
| 21 | A1 | B2 | C0 | D3 | E1 | F2 | G2 | H3 |
| 22 | A0 | B2 | C0 | D3 | E1 | F2 | G2 | H3 |
| 23 | A0 | B3 | C0 | D3 | E1 | F2 | G2 | H3 |
| 24 | A1 | B2 | C0 | D3 | E1 | F2 | G0 | H3 |
| 25 | A0 | B2 | C0 | D3 | E1 | F2 | G0 | H3 |

| 3^{ème} quadrant | | | | | | | | |
|---|---|---|---|---|---|---|---|---|
| zone 26 | A1 | B1 | C2 | D3 | E2 | F3 | G1 | H1 |
| 27 | A1 | B1 | C2 | D3 | E0 | F3 | G2 | H1 |
| 28 | A0 | B3 | C2 | D3 | E0 | F3 | G2 | H1 |
| 29 | A2 | B1 | C2 | D1 | E2 | F3 | G1 | H1 |
| 30 | A2 | B1 | C2 | D1 | E0 | F3 | G2 | H1 |
| 31 | A0 | B3 | C2 | D1 | E0 | F3 | G2 | H1 |
| 32 | A2 | B3 | C2 | D1 | E0 | F3 | G2 | H1 |
| 33 | A2 | B1 | C2 | D1 | E2 | F3 | G3 | H0 |
| 34 | A2 | B1 | C2 | D1 | E0 | F3 | G2 | H0 |
| 35 | A2 | B3 | C2 | D1 | E0 | F3 | G2 | H0 |
| 36 | A0 | B3 | C2 | D1 | E0 | F3 | G2 | H0 |
| 37 | A2 | B1 | C2 | D1 | E0 | F3 | G3 | H0 |
| 38 | A2 | B3 | C2 | D1 | E0 | F3 | G3 | H0 |

| 4^{ème} quadrant | | | | | | | | |
|---|---|---|---|---|---|---|---|---|
| zone 39 | A1 | B1 | C3 | D2 | E2 | F3 | G1 | H1 |
| 40 | A1 | B1 | C3 | D2 | E2 | F1 | G1 | H2 |
| 41 | A3 | B0 | C3 | D2 | E2 | F1 | G1 | H2 |
| 42 | A2 | B1 | C3 | D0 | E2 | F3 | G1 | H1 |
| 43 | A2 | B1 | C3 | D0 | E2 | F1 | G1 | H2 |
| 44 | A3 | B0 | C3 | D0 | E2 | F1 | G1 | H2 |
| 45 | A2 | B0 | C3 | D0 | E2 | F1 | G1 | H2 |
| 46 | A2 | B1 | C3 | D0 | E2 | F3 | G3 | H0 |
| 47 | A2 | B1 | C3 | D0 | E2 | F1 | G3 | H2 |
| 48 | A2 | B0 | C3 | D0 | E2 | F1 | G3 | H2 |
| 49 | A3 | B0 | C3 | D0 | E2 | F1 | G3 | H2 |
| 50 | A2 | B1 | C3 | D0 | E2 | F1 | G3 | H0 |
| 51 | A2 | B0 | C3 | D0 | E2 | F1 | G3 | H0 |

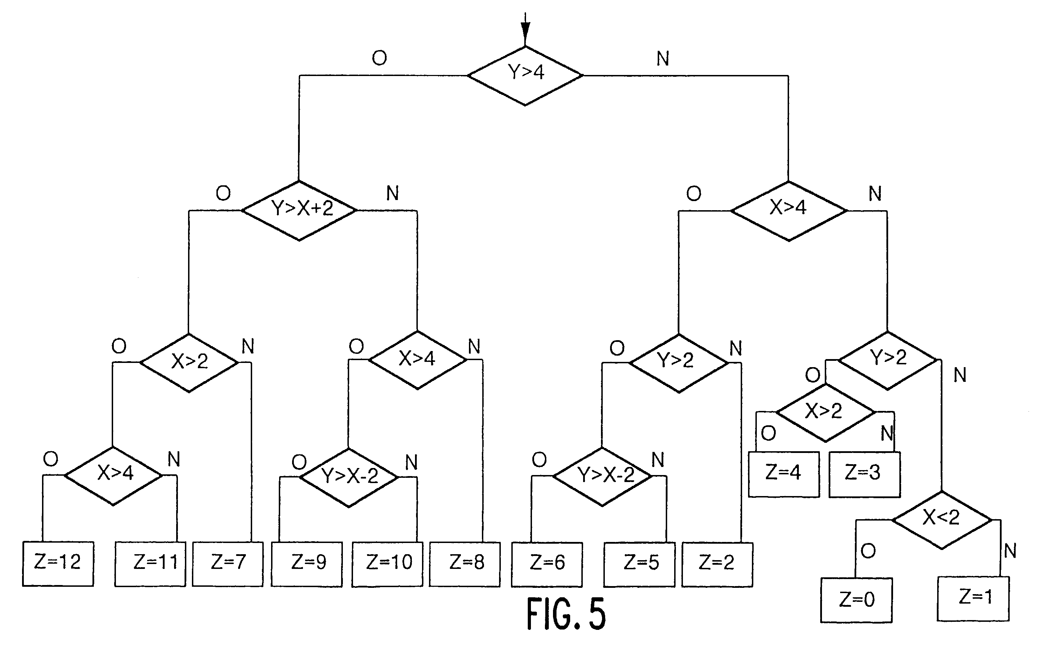

Ce module 2 de recherche de zone détermine la zone du quadrant de référence à laquelle appartient le point R' par dichotomie selon l'algorithme représenté sur la figure 5 par exemple. D'autres algorithmes équivalents sont utilisables.

Chaque étape de l'algorithme consiste à faire un test sur les coordonnées Xr' et Yr' du point R' pour le situer d'un côté ou de l'autre des droites d'équations Y=4, Y=X+2, X=2, X=4, Y=2, et Y=X-2 qui constituent les frontières qui délimitent les différentes zones dans le plan complexe. Le numéro de la zone contenant le point R' étant déterminé, le module 2 l'ajoute à la variable index de façon à obtenir le numéro Zr de la zone du quadrant initial qui contient le point R reçu. Le module 2 commande alors la lecture de la ligne Zr de la table 3 qui délivre ainsi sur la sortie 4 les 16 éléments binaires relatifs aux huit points de la constellation les plus proches du point R. Par exemple, si le point reçu R appartient à la zone Z0, la ligne 0 de la table fournit les 16 éléments binaires formés par la succession des deux éléments binaires Q3 et Q4 des huit points appartenant respectivement aux sous-ensembles A à H, c'est-à-dire A1, B1, C3, D2, E3, F2, G1, et H1. Ce sont ces 16 éléments binaires qui sont fournis en sortie dudit dispositif de décision.

Le module 2 de recherche de zone par dichotomie met donc en oeuvre quatre tests simples dans le pire des cas, ce qui signifie, en prenant en compte le test sur le quadrant initial réalisé par le module 1 de pré-traitement, que seuls cinq tests et une unique lecture de table sont nécessaires pour déterminer les huit points les plus proches du point reçu R. Pour un débit de transmission supérieur, et donc pour une constellation plus importante, seuls quelques tests supplémentaires seront nécessaires. Par exemple, lorsque la vitesse de transmission double, il suffit d'effectuer un test supplémentaire.

Dans un mode de réalisation particulièrement avantageux, ledit dispositif de décision est composé à partir d'un ensemble à microprocesseur 11 comprenant un microprocesseur proprement dit 12, d'une mémoire vive de travail 13, et d'une mémoire morte 14 contenant des instructions nécessaires à la mise en oeuvre de l'invention.

En particulier, les modems haut débit qui utilisent des modulations codées en treillis comportent avantageusement un dispositif de décision tel que décrit ci-dessus.

D'après la figure 6, un modem selon l'invention, qui porte la référence 6, permet de connecter un terminal numérique 5 à une ligne de transmission de type ligne téléphonique 7. Ce modem comporte des ensembles à microprocesseurs 10 et 11, un premier circuit d'interface 15 qui permet de le relier au terminal 5, et un second circuit d'interface 20 qui permet de transformer les signaux en provenance de la ligne téléphonique 7 en signaux numériques et réciproquement. Ce circuit d'interface 20 est décrit dans le brevet européen n°0318105.

L'ensemble à microprocesseur 10 est affecté à la gestion du modem, et l'ensemble 11 qui assure les opérations de transmission, comporte un microprocesseur 12, une mémoire vive de travail 13 et une mémoire morte 14 contenant en outre les instructions permettant de mettre en oeuvre ledit dispositif de décision.

Ainsi, il est possible de réaliser un modem selon l'invention, à 19200eb/s par exemple, avec une charge de calcul très peu supérieure à celle d'un modem selon l'art antérieur à 14400eb/s, conforme à la recommandation V32bis, ce qui permet de conserver le même architecture : seule la mémoire morte 14 doit être remplacée pour passer par exemple d'un modem à 14400eb/s selon l'art antérieur à un modem à 19200eb/s selon l'invention. Ceci est un avantage particulièrement important d'un point de vue commercial.

Il va de soi que des modifications peuvent être apportées au mode de réalisation qui vient d'être décrit, notamment par substitution de moyens techniques équivalents, sans que l'on sorte pour cela du cadre de la présente invention.

## Revendications

1. Système de transmission utilisant des modulations codées en treillis basées sur une constellation décomposée en N sous-ensembles, et comportant une source de données et un récepteur de données qui comporte lui-même un dispositif de décision permettant de déterminer le point le plus proche d'un symbole reçu dans chaque sous-ensemble de la constellation, lui associant ainsi une combinaison de N points,
caractérisé en ce que, la constellation étant découpée en zones correspondant chacune à une combinaison donnée de N points, ledit dispositif de décision comporte un module (2) de recherche de la zone dans laquelle se situe le symbole reçu, et une table (4) dont la lecture fournit la combinaison correspondant à cette zone.

2. Système de transmission selon la revendication 1, caractérisé en ce que le module (2) de recherche de zone détermine la zone recherchée par dichotomie relativement aux frontières des différentes zones.

3. Système de transmission selon la revendication 2, caractérisé en ce que les frontières des différentes zones sont des droites.

4. Système de transmission selon l'une des revendications 1 à 3, caractérisé en ce que ledit dispositif de décision comporte un module (1) de pré-traitement qui permet de ramener par symétrie tout point reçu dans un des quatre quadrants du plan, choisi comme référence pour y effectuer la recherche, et dit quadrant de référence, et en ce que les numéros de zone dans chacun des quadrants sont choisis de telle sorte qu'une opération mathématique "addition d'une constante" permette de passer du numéro de zone obtenu dans le quadrant de référence aux numéros des zones qui lui sont symétriques par rapport aux axes du plan de la constellation dans les autres quadrants.

5. Système de transmission selon la revendication 4, caractérisé en ce que les modules (1) et (2) de pré-traitement et de recherche de zone, et la table (3) sont formés à partir d'un ensemble à microprocesseur.

6. Modem utilisant des modulations codées en treillis basées sur une constellation décomposée en N sous-ensembles, et comportant un dispositif de décision qui permet de déterminer le point le plus proche d'un symbole reçu dans chaque sous-ensemble de la constellation, lui associant ainsi une combinaison de N points, caractérisé en ce que, la constellation étant découpée en zones correspondant chacune à une combinaison donnée de N points, ledit dispositif de décision comporte un module (2) de recherche de la zone dans laquelle se situe le symbole reçu, et une table (4) dont la lecture fournit la combinaison correspondant à cette zone.

7. Modem selon la revendication 6, caractérisé en ce que le module (2) de recherche de zone détermine la zone recherchée par dichotomie relativement aux frontières des différentes zones.

8. Modem selon la revendication 7, caractérisé en ce que les frontières des différentes zones sont des droites.

9. Modem selon l'une des revendications 6 à 8, caractérisé en ce que ledit dispositif de décision comporte un module (1) de pré-traitement qui permet de ramener par symétrie tout point reçu dans un des quatre quadrants du plan, choisi comme référence pour y effectuer la recherche, et dit quadrant de référence, et en ce que les numéros de zone dans chacun des quadrants sont choisis de telle sorte qu'une opération mathématique "addition d'une constante" permette de passer du numéro de zone obtenu dans le quadrant de référence aux numéros des zones qui lui sont symétriques par rapport aux axes du plan de la constellation dans les autres quadrants.

10. Modem selon la revendication 9, caractérisé en ce que les modules (1) et (2) de pré-traitement et de recherche de zone, et la table (3) sont formés à partir d'un ensemble à microprocesseur.

## Patentansprüche

1. Übertragungssystem unter Verwendung von gitterkodierten Modulationen, gründend auf einer in N Unterensembles aufgegliederten Konstellation, und eine Datenquelle und einen Datenempfänger enthaltend, der selbst eine Entscheidungsvorrichtung enthält, um die Bestimmung des Punktes zu ermöglichen, der am nächsten an einem Symbol liegt, in jedem der Unterensembles der Konstellation erhalten, um ihm so eine Kombination von N Punkten zuzuordnen,
dadurch gekennzeichnet, daß die Konstellation in Zonen unterteilt ist, die jeweils einer gegebenen Kombination von N Punkten entsprechen, die besagte Entscheidungsvorrichtung ein Suchmodul (2) der Zone enthält, in der sich das erhaltene Symbol befindet, und eine Tabelle (4), deren Lesen die zu dieser Zone entsprechende Kombination liefert.

2. Übertragungssystem nach Anspruch 1, dadurch gekennzeichnet, daß das Zonensuchmodul (2) die gesuchte Zone per Dichotomie relativ zu den Grenzen der verschiedenen Zonen bestimmt.

3. Übertragungssystem nach Anspruch 2, dadurch gekennzeichnet, daß die Grenzen der verschiedenen Zonen Gerade sind.

4. Übertragungssystem nach einem der Ansprüche 1 bis 3, dadurch gekennzeichnet, daß die besagte Entscheidungsvorrichtung ein Vorverarbeitungsmodul (1) enthält, das die symmetrische Rückführung aller Punkte ermöglicht, erhalten in einem der vier Quadranten der Fläche, gewählt als Referenz zum Durchführen der Suche und Referenzquadrant benannt, und dadurch, daß die Zonennummem in jedem der Quadranten derart gewählt werden, daß eine mathematische Operation "Addition einer Konstanten" es ermöglicht, von einer im Referenzquadranten erhaltenen Zonennummer zu den Zonennummem überzugehen, die zu ihm in bezug auf die Achsen des Konstellationsplans in den anderen Quadranten symmetrisch sind.

5. Übertragungssystem nach Anspruch 4, dadurch gekennzeichnet, daß die Vorverarbeitungs- und Zonensuchmodule (1) und (2) und die Tabelle (3) aus Mikroprozessorvorrichtungen gebildet werden.

6. Modem unter Verwendung von gitterkodierten Modulationen, gründend auf einer in N Unterensembles aufgegliederten Konstellation, und eine Entscheidungsvorrichtung enthaltend, das die Bestimmung des Punktes ermöglicht, der am nächsten an einem Symbol liegt, in jedem der Unterensembles der Konstellation erhalten, um ihm so eine Kombination von N Punkten zuzuordnen, dadurch gekennzeichnet, daß die Konstellation in Zonen unterteilt ist, die jeweils einer gegebenen Kombination von N Punkten entsprechen, die besagte Entscheidungsvorrichtung ein Suchmodul (2) der Zone enthält, in der sich das erhaltene Symbol befindet, und eine Tabelle (4), deren Lesen die zu dieser Zone entsprechende Kombination liefert.

7. Modem nach Anspruch 6, dadurch gekennzeichnet, daß das Zonensuchmodul (2) die gesuchte Zone per Dichotomie relativ zu den Grenzen der verschiedenen Zonen bestimmt.

8. Modem nach Anspruch 7, dadurch gekennzeichnet, daß die Grenzen der verschiedenen Zonen Gerade sind.

9. Modem nach einem der Ansprüche 6 bis 8, dadurch gekennzeichnet, daß die besagte Entscheidungsvorrichtung ein Vorverarbeitungsmodul (1) enthält, das die symmetrische Rückführung aller Punkte ermöglicht, erhalten in einem der vier Quadranten der Fläche, gewählt als Referenz zum Durchführen der Suche und Referenzquadrant benannt, und dadurch, daß die Zonennummem in jedem der Quadranten derart gewählt werden, daß eine mathematische Operation "Addition einer Konstanten" es ermöglicht, von einer im Referenzquadranten erhaltenen Zonennummer zu den Zonennummem überzugehen, die zu ihm in bezug auf die Achsen des Konstellationsplans in den anderen Quadranten symmetrisch sind.

10. Modem nach Anspruch 9, dadurch gekennzeichnet, daß die Vorverarbeitungs- und Zonensuchmodule (1) und (2) und die Tabelle (3) aus Mikroprozessorvorrichtungen gebildet werden.

## Claims

1. A transmission system using trellis-coded modulations based on a constellation split up into N sub-sets, and comprising a data source and a data receiver which itself comprises a decision arrangement enabling to determine the closest point to a received symbol in each sub-set of the constellation by assigning to the received symbol a combination of N points, characterized in that, whilst the constellation is split up into zones corresponding each to a given combination of N points, said decision arrangement comprises a searching module (2) for searching the zone in which the received symbol is situated, and a Table (4) which provides, when read, the combination corresponding to this zone.

2. A transmission system as claimed in Claim 1, characterized in that the zone searching module (2) determines the searched zone by dichotomy with respect to the boundaries of the various zones.

3. A transmission system as claimed in Claim 2, characterized in that the boundaries of the various zones are straight lines.

4. A transmission system as claimed in one of the Claims 1 to 3, characterized in that the decision arrangement comprises a preprocessing module (1) which enables to restore by symmetry any received point in one of the four quadrants of the plane, selected as a reference plane to perform the searching operation there and called reference quadrant, and in that the numbers of the zones in each of the quadrants are selected such that a mathematical operation called "addition of a constant" enables to go from the number of the zone obtained in the reference quadrant to the numbers of the zones which are symmetrical with that zone along the axes of the plane of the constellation in the other quadrants.

5. A transmission system as claimed in Claim 4, characterized in that the preprocessing module (1) and the zone searching module (2) and the Table (3) are formed by a microprocessor unit.

6. A modem using trellis-coded modulations based on a constellation split up into N sub-sets, and comprising a decision arrangement which enables to determine the point closest to a received symbol in each sub-set of the constellation, assigning to the received symbol a combination of N points, characterized in that, whilst the constellation is split up into zones corresponding each to a given combination of N points, said decision arrangement comprises a searching module (2) for searching the zone in which the received symbol is situated, and a Table (4) which provides, when read, the combination corresponding to this zone.

7. A modem as claimed in Claim 6, characterized in that the zone searching module (2) determines the searched zone by dichotomy with respect to the boundaries of the various zones.

8. A modem as claimed in Claim 7, characterized in that the boundaries of the various zones are straight lines.

9. A modem as claimed in one of the Claims 6 to 8, characterized in that said decision arrangement comprises a preprocessing module (1) which enables to restore by symmetry any received point in one of the four quadrants of the plane, selected as a reference plane to perform the searching operation there and called reference quadrant, and in that the numbers of the zones in each of the quadrants are selected such that a mathematical operation called "addition of a constant" enables to go from the number of the zone obtained in the reference quadrant to the numbers of the zones which are symmetrical with that zone along the axes of the plane of the constellation in the other quadrants.

10. A modem as claimed in Claim 9, characterized in that the preprocessing module (1) and zone searching module (2) and the Table (3) are formed by a microprocessor unit.
